# NEW EUROPEAN PATENT SPECIFICATION

(11) **EP 0 612 463 B2**
(45) Date of publication and mention of the opposition decision: **24.05.2000**
(45) Mention of the grant of the patent: 17.04.1996
(21) Application number: 92902334.9
(22) Date of filing: 04.12.1991
(51) Int. Cl.: H05K 3/42

(54) **DEVICE FOR FORMATION OF A FILM ON THE WALLS OF HOLES IN PRINTED CIRCUIT BOARDS**
ANORDNUNG ZUR HERSTELLUNG EINES FILMS AUF DIE LOECHERWAENDE IN GEDRUCKTEN SCHALTUNGEN
DISPOSITIF DE FORMATION D'UNE COUCHE SUR LES PAROIS DE TROUS MENAGES DANS LES CARTES A CIRCUITS IMPRIMES

(30) Priority: 12.11.1991 IT MI913003
(43) Date of publication of application: 31.08.1994
(73) Proprietor: OCCLEPPO DI FRANCESCO OCCLEPPO & C. SNC, 13040 Alice Castello (IT)
(72) Inventor: OCCLEPPO, Francesco, I-13040 Alice Castello (IT)
(74) Representative: Leske, Thomas, Dr.
(86) International application number: IT9100105
(87) International publication number: WO9310653

(56) References cited:
- EP-A- 0 194 247
- EP-A- 0 212 253
- EP-A- 0 327 298
- EP-A- 0 424 798
- DE-A- 2 215 623
- DE-A- 3 916 694

## Description

The invention concerns a device for formation of a film on the walls of small holes in boards for printed circuits.

A device for the formation of such films, according to the preamble of claim 1, is disclosed in EP-A-0 424 798. The circuit boards are immersed in a special bath so that a protective or antioxidizing film, or some film to improve surface quality, may be formed on said boards and especially on the walls of the holes bored through them. The components of said bath determine chemical reactions on the copper surfaces forming what is known as chemical tin or chemical copper or other products.

In mass production methods the boards follow each other through the bath moved along by some means of transport. This is clearly a lengthy process partly because the film deposited must be as uniform as possible.

The major difficulty arises over forming the film on the walls of the very small holes made in these boards since passage of the liquid through them is hindered by their minute diameters and also because their walls lie orthogonally to the direction in which the boards move especially if this movement is parallel to their greater surfaces.

While the horizontal disposition of the boards may be optimum from the structural and functional standpoints, it does not facilitate action by gravity of the chemical agents on the sides of the above holes which, as said above, lie orthogonally to the surfaces of the boards.

Purpose of the present invention is to shorten working times and also to ensure the best possible formation of film inside the holes, as will be explained below.

Subject of the invention is a device for forming a film on the walls of small holes bored in printed circuit boards by immersion of said boards in a tank containing a specific liquid product.

One or more sets of nozzles, orthogonal to board movement, are placed in the tank in a position corresponding to that of the boards, said tank also containing a pump that continually takes up liquid and returns it to the bath under pressure applied through said nozzles.

In this way currents of liquid are made to flow through said holes.

The chemical reaction between the bath's components and the copper sides of the holes can result in formation of a film of chemical tin, chemical copper or of some other substance, as the case may be.

A special mechanism causes the boards to move along continuously on a level parallel to their greater surface and to the free surface of the liquid.

Preferably the tank contains sets of 'suction' nozzles through which liquid is taken from the bath, said sets alternating with other sets of pressure nozzles, also orthogonal to movement of the boards and in a position corresponding to that of said boards, through which second responding to that of said boards, through which second set the liquid is returned to the bath.

Entry point of a pump is connected to the suction nozzles and its exit point to the pressure nozzles.

The nozzles of each set are fed on a plane which is orthogonal and transversal to movement of the boards.

In this way currents of liquid, alternating in one direction and in the opposite direction, will pass through the holes and in doing so speed up and improve formation of the desired film.

The nozzles consist of thin rectangular openings, each set being aligned transversally to the direction in which the boards move, the purpose of this being to set up laminar currents transversal to this movement.

In one execution each set of nozzles consists of several longitudinal slit-like mouths, placed along the top of horizontal cylindrical tubes.

These tubes are parallel, transversal to movement of the boards, some being joined by vertical connections to a longitudinal tube fixed to the entry side of the pump, and others to another tube, parallel to the first one, fixed to the exit side of the pump.

The invention offers some evident advantages. The currents of liquid in the tank flowing in opposite directions and passing back and forth inside the holes in the boards moving along the tank, increase the amount of movement between said liquid and the walls of the holes. This signifies an increase in the speed at which particles of liquid are deposited and in the chemical reactions that give rise to formation of film on the walls of said holes.

Not only does the invention achieve this but it also reduces costs of manufacturing printed circuits and improves their quality.

Characteristics and purposes of the invention will be made still clearer by the example of its execution here following illustrated by diagrammatic figures.

### Examples of execution

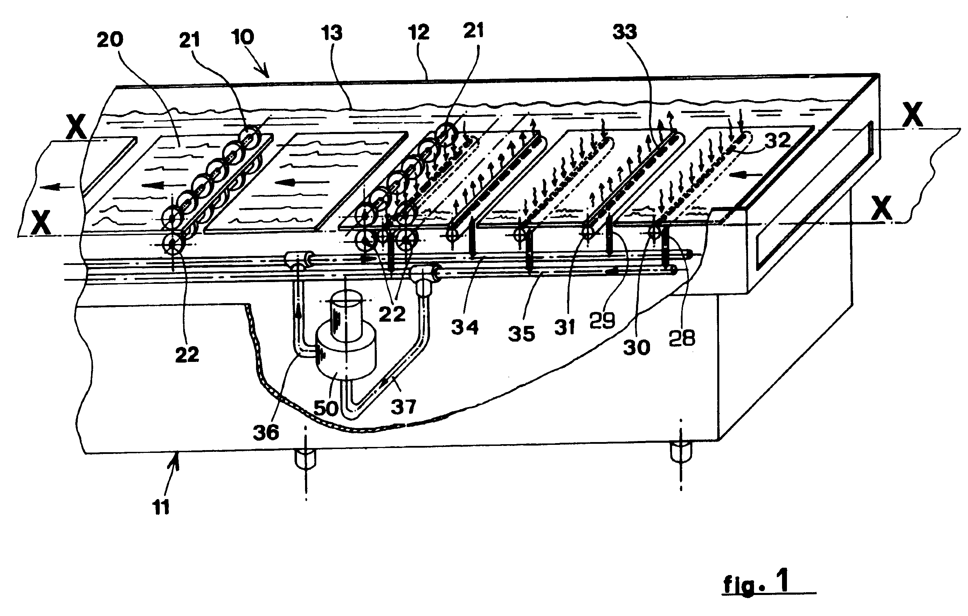

- Fig. 1: Perspective view of an apparatus for printed circuits with the device subject of the invention.

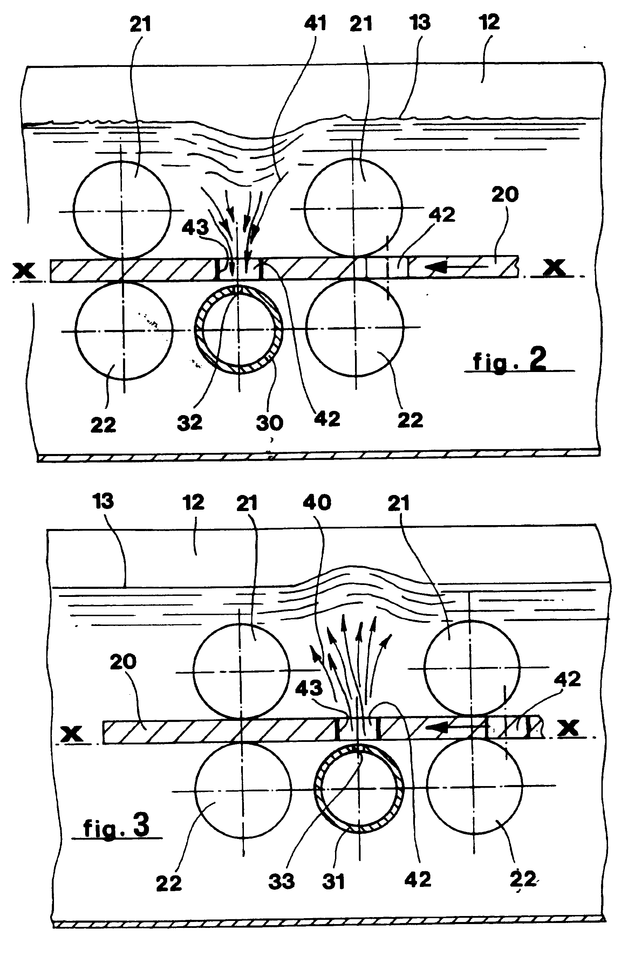

- Fig. 2: Detailed view of the 'suction' nozzles.
- Fig. 3: Detailed view of the pressure nozzles.

The device 10 comprises the frame 11 and tank 12 for holding the liquid product 13 that gives a chemical reaction on the boards 20 of printed circuits.

Said boards 20 are made to slide on a horizontal geometrical plane, indicated by XX, by means of two sets of motor-driven wheels 21 and 22 one above and the other below said plane.

The sets of transversal parallel manifolds 30 and 31, respectively alternated, are placed at established intervals below said plane XX.

Aligned on the upper side of said manifolds are the rectangular nozzles, 32 and 33 respectively.

The manifolds 30 are joined by connections 28 to the longitudinal tube 34 while manifolds 31 are joined by connections 29 to the longitudinal tube 35 parallel to the first one.

The tube 34 is connected to the exit side 36 of the pump 50 while the tube 35 is connected to the entry side 37 of said pump.

By means of this pump the liquid 13 contained in the tank 12 is continually recycled since it is sucked up through the nozzles 32 and returned through nozzles 33 with the current 40 flowing upward and thus towards the printed circuit boards 20, and the current 41 caused by said boards to flow downward.

Penetration of said current 40 inside the holes 42 in the printed circuit boards and current 41 flowing out from said holes 42, increases the movement of liquid in relation to the walls of the holes and this in turn increases and potentiates the chemical reaction that leads to gradual formation of the film 43, especially of chemical tin or chemical copper on said walls.

## Claims

1. Device (10) for formation of a film (43) on the walls of small holes (42) in boards (20) for printed circuits by chemical reaction obtained during their immersion in a liquid product (13) contained in a bath (12), wherein the device comprises at least one set of suction nozzles and at least one set of pressure nozzles orthogonally to said boards during said immersion and aligned in a position transversely to said moving direction of said boards and comprises a pump (50) that continually takes up liquid (13) from the bath (12) through said set of suction nozzles (32) and returns it under pressure to said bath (12) through said set of pressure nozzles (33) creating currents (40, 41) of said liquid passing directly from said nozzles to said boards through the holes (42) back and forth therein to increase movement between the liquid (13) and the walls of said holes (42) to accelerate and improve formation of the film (43).

2. Device (10) as in claim 1
characterized in that the film (43) is of chemical tin.

3. Device as in claim 1
characterized in that the film (43) is of chemical copper.

4. Device (10) as in claim 1
characterized in that specially provided mechanisms (21) (22) determine continuous translation,on the level,of the boards (20), parallel to themselves and to the free surface of the liquid (13).

5. Device (10) as in claim 1
characterized in that a specially provided mechanism (21) (22) determines continuous translation, on the level, of the boards (20), parallel to their greater surface and to the free surface of the liquid (13), there being one or more sets of suction nozzles (32) by which the liquid (13) is drawn up from the bath (12), alternating with other sets of pressure nozzles (33) by means of which the pump (50) returns the liquid (13) to the bath (12), this setting up inside the holes (42) in the translating boards (20), currents (41) of liquid (13) moving in one direction and currents (40) of liquid moving in the opposite direction, the purpose of this being to accelerate and further improve formation of the film (43).

6. Device (10) as in claim 5
characterized in that the nozzles (32) (33) have thin rectangular mouths aligned,in each set, transversal to the moving direction the boards (20) in order to determine laminar currents transversal to said direction of the boards.

7. Device (10) as in claim 5
characterized in that a pump (50) is connected at its entry side (37) to the suction nozzles (32) and at its exit side (36) to the pressure nozzles (33), said pump (50) therefore simultaneously sucking up the liquid (13) from the bath (12) and returning it thereto.

8. Device (10) as in claim 5
characterized in that each set of nozzles (32) (33) is obtained from a quantity of longitudinal slit-like mouths aligned and made in the top of horizontal cylindrical manifolds (30) (31), parallel and transversal to the moving direction of the boards (20), some being joined by vertical connections (28) (29) to one longitudinal tube (35) fixed to the entry side (37) of the pump (50) and others to another tube (34) parallel to the first one and connected to the exit side (36) of the pump (50).

## Patentansprüche

1. Vorrichtung (10) für die Herstellung eines Films (43) auf den Wänden kleiner Löcher (42) in Platten (20) für gedruckte Schaltungen durch eine chemische Reaktion, welche während deren Eintauchen in ein flüssiges Produkt (13) erhalten wird, welches in einem Becken (12) enthalten ist, wobei die Vorrichtung mindestens eine Reihe von Saugdüsen und mindestens eine Reihe von Druckdüsen umfaßt, welche während des Eintauchens orthogonal zu den Platten sind und in einer Position transversal zu der Bewegungsrichtung der Platten ausgerichtet sind, und eine Pumpe (50) umfaßt, welche kontinuierlich Flüssigkeit (13) aus dem Becken (12) durch die Reihe von Saugdüsen (32) entnimmt und sie unter Druck über die Reihe von Druckdüsen (33) in das Becken (12) zurückführt, wobei Strömungen (40, 41) der Flüssigkeit erzeugt werden, welche direkt von den Düsen zu den Platten durch die Löcher (42), darin hin und her, verlaufen, um die Bewegung zwischen der Flüssigkeit (13) und den Wänden der Löcher (42) zu steigern, um die Bildung des Films (43) zu beschleunigen und zu verbessern.

2. Vorrichtung (10) gemäß Anspruch 1), dadurch gekennzeichnet, daß der Film (43) aus chemischem Zinn ist.

3. Vorrichtung gemäß Anspruch 1), dadurch gekennzeichnet, daß der Film (43) aus chemischem Kupfer ist.

4. Vorrichtung (10) gemäß Anspruch 1), dadurch gekennzeichnet, daß ein entsprechender Kinematismus (21), (22) die ständige, waagerechte Translation der Platten (20) parallel zu sich selbst und dem freien Spiegel der Flüssigkeit (13) verursacht.

5. Vorrichtung (10) laut Anspruch 1), dadurch gekennzeichnet, daß ein entsprechender Kinematismus (21), (22) die ständige, waagerechte Translation der Platten (20) parallel zu deren größerer Oberfläche und dem freien Spiegel der Flüssigkeit (13) verursacht, wobei eine oder mehrere Reihen sogenannter Saugdüsen (32) vorgesehen sind, von denen die Flüssigkeit (13) aus dem Becken (12) gesaugt wird, und zwar abwechselnd mit anderen Düsenreihen (33), sogenannten Druckdüsen, durch die die Pumpe (50) die Flüssigkeit (13) wieder in das Becken (12) läßt, wodurch in den kleinen Löchern (42) der sich verschiebenden Platten (20) Flüssigkeits-(13) Ströme (41), die in einer Richtung, und Flüssigkeits- (13) Ströme (40) gebildet werden, die in der entgegengesetzten Richtung verlaufen, und zwar um die Bildung des Films (43) zu beschleunigen und zu verbessern.

6. Vorrichtung (10) gemäß Anspruch 5), dadurch gekennzeichnet, daß die Dosen (32), (33) schmale rechteckige Öffnungen aufweisen, die bei jeder Reihe quer zur Translationsrichtung der Platten (20) ausgerichtet sind, und zwar um quer zu dieser Translation verlaufende laminare Ströme zu erzeugen.

7. Vorrichtung (10) gemäß Anspruch 5), dadurch gekennzeichnet, daß eine Pumpe (50) an ihrem Einlaß (37) mit den Saugdüsen (32) und an ihrem Auslaß (36) mit den Druckdüsen (33) verbunden ist, wobei diese Pumpe (50) gleichzeitig für die Ansaugung des Flüssigkeit (13) aus dem Becken (12) und deren Wiedereinlaß in dasselbe sorgt.

8. Vorrichtung (10) gemäß Anspruch 5), dadurch gekennzeichnet, daß eine Reihe Dosen (32), (33), die durch eine Vielfalt von schlitzförmigen Längsöffnungen gebildet wird, die an der Spitze von Sammlern (30), (31) ausgerichtet und angeordnet sind, die zylindrisch und horizontal sind und parallel und quer zur Translation der Platten (20) verlaufen, und mit senkrechten Anschlußstücken (28), (29) zum Teil an eine Längsleitung (35) und an den Einlaß (37) der Pumpe (50) angeschlossen sind, und zum Teil mit einer zweiten Leitung (34) verbunden sind, die parallel zur ersten verläuft und an den Auslaß (36) der Pumpe (50) angeschlossen ist.

## Revendications

1. Dispositif (10) pour la formation d'une pellicule (43) sur les parois de petits trous (42) dans des plaques (20) pour circuits imprimés par réaction chimique obtenue pendant l'immersion dans un produit liquide (13) contenu dans un bain (12) dans lequel le dispositif comprend au moins une série de buses d'aspiration et au moins une série de buses de pression perpendiculairement auxdites plaques pendant ladite immersion et alignées dans une position transversalement à ladite direction de déplacement desdites plaques et comprend une pompe (50) qui prélève continuellement du liquide (13) du bain (12) par l'intermédiaire de ladite série de buses d'aspiration (32) et qui le réintroduit sous pression dans ledit bain (12) par l'intermédiaire de ladite série de buse de pression (33) en créant des courants (40, 41) dudit liquide passant directement desdites buses auxdites plaques à travers les trous (42) en aller et retour dedans pour augmenter le mouvement entre le liquide (13) et les parois desdits trous (42) pour accélérer et améliorer la formation de la pellicule (43).

2. Dispositif (10) conformément à la revendication 1), caractérisé par le fait que la pellicule (43) est en étain chimique.

3. Dispositif conformément à la revendication 1), caractérisé par le fait que la pellicule (43) est en cuivre chimique.

4. Dispositif (10) conformément à la revendication 1), caractérisé par le fait qu'un cinématisme spécial (21), (22) détermine la translation en continuité des plaques (20) à plat, parallèlement à celles-ci et au fil libre du liquide (13).

5. Dispositif (10) conformément à la revendication 1), caractérisé par le fait qu'un cinématisme spécial (21), (22) détermine la translation en continuité des plaques (20) à plat, parallèlement à leur surface majeure et au fil libre du liquide (13),étant prédisposées une ou plusieurs séries de buses (32) appelées d'aspiration, d'où le liquide (13) est aspiré par la cuve (12), alternées à d'autres séries de buses (33) appelées de pression, à travers lesquelles la pompe (50) admet de nouveau le liquide (13) dans la cuve (12), se déterminant par conséquent dans les petits trous (42) des plaques (20) de translation, des courants (41) de liquide (13) orientées dans un sens et des courants (40) de liquide orienté dans le sens opposé et cela dans le but d'accélérer et d'améliorer ultérieurement la formation de la pellicule (43).

6. Dispositif (10) conformément à la revendication 5), caractérisé par le fait que les buses (32), (33) ont des ouvertures rectangulaires fines, alignées dans chaque série, transversalement à la direction de translation des plaques (20) et cela dans le but de déterminer des courants laminaires transversaux à cette translation.

7. Dispositif (10) conformément à la revendication 5), caractérisé par le fait qu'une pompe (50) est reliée à son entrée (37) aux buses (32) appelées d'admission et à sa sortie (36) par des buses (33) appelées de pression, cette pompe (50) effectuant donc simultanément l'aspiration du liquide (13) de la cuve (12) et l'admettant de nouveau dans celle-ci.

8. Dispositif (10) conformément à la revendication 5), caractérisé par le fait que chaque série de buses (32), (33), obtenue par une pluralité de bouches en fente longitudinales, alignées et prédisposées au sommet de collecteurs (30), (31) cylindriques horizontaux, parallèles et transversaux à la translation des plaques (20) et reliés par des raccords (28), (29) verticaux, en partie à une tuyauterie (35) longitudinale et reliée à l'entrée (37) de la pompe (50), et en partie à une seconde conduite (34), parallèle à la première, reliée à la sortie (35) de la pompe (50).
